# EUROPEAN PATENT SPECIFICATION

(11) **EP 1 700 300 B1**
(45) Date of publication and mention of the grant of the patent: **05.03.2008**
(21) Application number: 04806394.5
(22) Date of filing: 14.12.2004
(51) Int. Cl.: G11B 7/13, G11B 7/135, H01S 5/183

(54) **IMPROVED OPTICAL READ-OUT.**
VERBESSERTES OPTISCHES AUSLESEN
AFFICHAGE OPTIQUE AMELIORE

(30) Priority: 24.12.2003 EP 03300290
(43) Date of publication of application: 13.09.2006
(73) Proprietor: Koninklijke Philips Electronics N.V., 5621 BA Eindhoven (NL)
(72) Inventor: ANDERSEN, Ole, Klembt Société Civile SPID, F-75008 Paris (FR); HENDRIKS, Robert, Frans, Maria Société Civile SPID, F-75008 Paris (FR); VAN DER LEE, Alexander, Marc Société Civile SPID, F-75008 Paris (FR); VAN DER WERF, Jan, Evert Société Civile SPID, F-75008 Paris (FR)
(74) Representative: van Oudheusden-Perset, Laure E.
(86) International application number: PCT/IB2004/004212
(87) International publication number: WO 2005/066946

(56) References cited:
- US-B1- 6 574 257
- GEORGE PAN Z ET AL: "OPTICAL INJECTION INDUCED POLARIZATION BISTABILITY IN VERTICAL-CAVITY SURFACE-EMITTING LASERS" APPLIED PHYSICS LETTERS, AMERICAN INSTITUTE OF PHYSICS. NEW YORK, US, vol. 63, no. 22, 29 November 1993 (1993-11-29), pages 2999-3001, XP000414956 ISSN: 0003-6951
- HUDGINGS J A ET AL: "COMPACT, INTEGRATED OPTICAL DISK READOUT HEAD USING A NOVEL BISTABLE VERTICAL-CAVITY SURFACE-EMITTING LASER" IEEE PHOTONICS TECHNOLOGY LETTERS, IEEE INC. NEW YORK, US, vol. 11, no. 2, February 1999 (1999-02), pages 245-247, XP000803439 ISSN: 1041-1135

## Description

### Field of the invention

The present invention relates to an arrangement for read-out of information from an optical information carrier, wherein the optical read-out is improved by a non-linear element in the form of a vertical-cavity surface-emitting laser (VCSEL). The invention also relates to an optical drive comprising such an arrangement, and to the use of a VCSEL for enhancing read-out of information.

### Background of the invention

The read-out signal from an optical information carrier is typically noisy due to various reasons. For example, the light source used for illuminating the information carrier is typically of low power, making the device particularly sensitive to noise. Moreover, the amount of reflected light can vary unexpectedly due to a non-uniform reflectivity of the information carrier. In addition, detector noise may be an important limiting factor to the quality of the optical read-out.

Therefore, a number of measures have been proposed to increase the power and/or signal-to-noise ratio of the optical read-out signal reflected from the information carrier. One such proposal has been to use injection of light from a master laser into a slave laser, after the light from the master laser has been reflected from, and thereby modulated by, the surface of the information carrier. A large amplitude optical read-out signal can thus be obtained as a result of the known phenomenon of injection-locking of diode lasers.

In future high-density optical disc-drives, such as for blu-ray discs and SFFO-discs (Small Form Factor Optical discs), detector noise severely hampers the information read-out. In fact, the detector noise is the dominant source of noise in these devices. In order to cope with this problem, it has been proposed to amplify the light incident upon the detector by the use of some non-linear optical element (NOE). One implementation of the NOE for this purpose that seems promising is the use of a vertical-cavity surface-emitting laser (VCSEL). However, when light is injected into a VCSEL in order to achieve injection locking, the emitted light from the VCSEL is counter-propagating to the injected light. Although this can be handled, it results in an increased complexity of the light-path of the device.

US 6,574,257 (cf. the preamble of claim 1) discloses a near-field laser and detector apparatus wherein both writing and reading of optical media can be carried out using the same laser operating in a single mode for both read and write operations. The threshold current and output intensity of a VCSEL are responsive to feedback light reflected back into the VCSEL from the optical medium, with low reflectivity spots in the medium providing less reflective feedback to the VCSEL, while high reflectivity regions provide greater reflective feedback. The drive current or bias current of the VCSEL is maintained well above the threshold currents associated with both high and low reflectivity feedback, such that a high level output intensity is emitted from a front facet which undergoes minimal change according to changes in reflective feedback to facilitate writing. At the same time, the output power from a rear facet undergoes substantial change according to reflective feedback.

As a further general background, Applied Physics Letters, 63 (1993), 29 Nov. No 22, pages 2999-3001 (Pan *et al*.) discusses optical injection induced polarization bistability in VCSELs.

Thus, there is a need in the art for a VCSEL-based optical system for read-out of information from an optical information carrier, which system has reduced complexity.

### Summary of the invention

Traditionally, VCSELs are grown on a non-transparent substrate, which means that the light rays injected into the VCSEL and the light rays emitted by the VCSEL are counter-propagating. The complexity of a read-out device incorporating a VCSEL for enhancing the quality of the read-out signal is therefore quite large. This can be particularly problematic for SFFO-discs, and is a general drawback in terms of design.

Therefore, it is an object of the present invention to provide an optical system in which a VCSEL is used as a non-linear optical element for improving the signal-to-noise ratio of the optical read-out signal, wherein the VCSEL is integrated with a reduced complexity compared to the prior art.

Previously, light reflected from an optical disc has been injected into the VCSEL, which in turn emits linearly polarized light of a power much larger than the injected power. In this way, the light reflected from the disc is amplified. The light emitted by the VCSEL (such as the power and polarization thereof) is detected in order to retrieve the information contained in the light reflected from the disc.

However, and as mentioned above, VCSELs are typically grown on a substrate which absorbs or reflects the emitted light, such that light is effectively only emitted in one direction from the VCSEL. When a VCSEL of this kind is integrated into the detection branch of the light-path in an optical read-out device, the light rays injected into the VCSEL and the light rays emitted by the VCSEL are counter-propagating. Hence, this is the root of the large complexity for the optical set-up of the device. Namely, since these rays are counter-propagating, some additional distinguishing means must be introduced. For example, this can be done by arranging a beam splitter, such as a dichroic mirror or a polarizing beam splitter, in the beam-path in front of the VCSEL. Such beam splitter is typically designed to transmit the light used for injection (i.e. the light reflected from the optical disc) and to reflect the emission from the VCSEL.

To reduce the required complexity of the light-path, it is proposed according to the present invention to use a VCSEL having the ability to emit light in two directions. To this end, the invention proposes the use of a VCSEL having a transmitting substrate, such that emission can take place the VCSEL in two directions. Therefore, the need for the above-mentioned distinguishing means in the form of a beam splitter is entirely eliminated and the complexity of the read-out device is reduced.

According to a first aspect of the present invention there is provided an arrangement for read-out of information from an optical information carrier as set forth in claim 1.

According to a second aspect of the present invention there is provided an optical drive as set forth in claim 5.

According to a third aspect of the present invention there is provided the use of a vertical-cavity surface-emitting laser (VCSEL) capable of receiving injection light from a first side and emitting light from a second, opposite side for enhancing read-out of information from an optical information carrier as set forth in claim 6.

In a first embodiment of the present invention, the substrate of the VCSEL is made transmitting simply by providing a hole through the substrate, for example by drilling or etching. Light generated by the VCSEL can then exit in two counter-propagating directions.

In a second embodiment of the present invention, the substrate of the VCSEL is selected to be of a material which is transparent to the wavelength emitted by the VCSEL. For example, such material could be gallium-phosphate (GaP) or sapphire (Al₂O₃). However, various other materials are also conceivable. The VCSEL could either be grown directly on a transparent substrate, or be provided with a transparent substrate after the VCSEL has been grown.

Hence, the basic idea of the present invention is the incorporation of a VCSEL into an arrangement for read-out of information from an optical information carrier, wherein said VCSEL is capable of receiving injection light from a first side and emitting light from a second side opposite to said first side. The information carrier is illuminated by a light source, and the light reflected from (and thereby modulated by) the information carrier is injected into the VCSEL from the first side. This injection of light into the VCSEL causes the emission of secondary light from the VCSEL, which light is at least partly emitted through the second side of said VCSEL and monitored for read-out. In this way, the need for beam splitters or the like in order to separate the injected light from the secondary light emitted by the VCSEL is eliminated, since the injected light and the secondary light emitted by the VCSEL propagates in substantially the same direction.

### Brief description of the drawings

Different features and advantages of the present invention will be better understood from the following detailed description of preferred embodiments, where reference is made to the accompanying drawings, on which:
Fig.1 schematically shows a cross-section of a typical VCSEL;
Fig.2 schematically shows the detection branch in a prior art optical read-out system, wherein a VCSEL is employed for improving the read-out signal;
Fig.3 schematically shows the detection branch in an optical read-out system according to the present invention;
Fig.4 schematically shows a VCSEL according to a first embodiment of the present invention; and
Fig.5 schematically shows a VCSEL according to a second embodiment of the present invention.

### Description of preferred embodiments

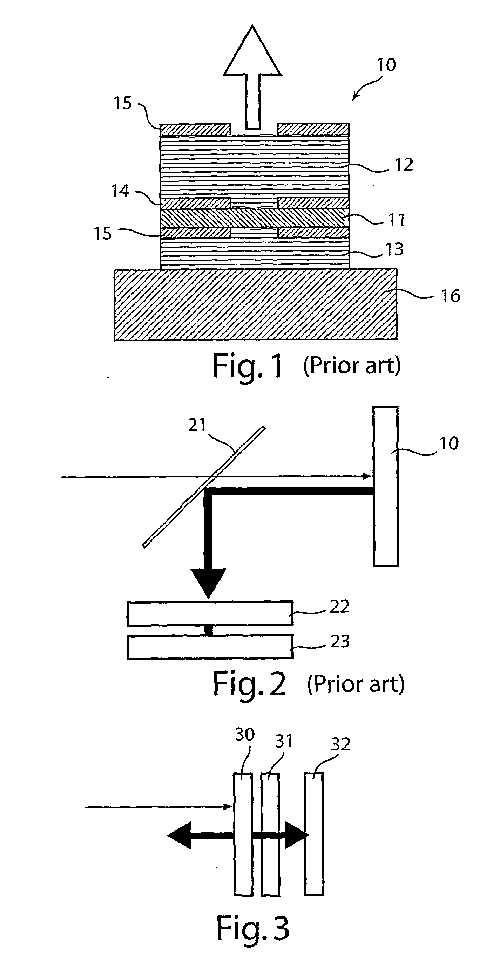

In order to give a clear description of the embodiments of the present invention, an arrangement according to the prior art will be described by way of introduction and with reference to figures 1 and 2 of the drawings.

Fig.1 shows a cross-section of a typical vertical-cavity surface-emitting laser (VCSEL) 10. The VCSEL comprises an active region 11 having multiple quantum wells and barriers, which active region is surrounded by a first and a second distributed Bragg reflector (DBR) 12 and 13 to provide optical feedback to the active region. Adjacent to the active region of the VCSEL, there are typically provided oxide layers 14 for defining the mode for the laser. Moreover, metal contacts 15 are provided for electrical connection to the VCSEL. The VCSEL is grown on a semiconductor substrate 16, typically gallium-arsenide (GaAs). The emission from the VCSEL is of a wavelength which is normally absorbed in the semiconductor substrate. Therefore, emission of light from the laser takes place in one direction only, as indicated by the arrow in the figure.

Fig.2 shows a set-up for VCSEL-assisted read-out from an optical information carrier (not shown), such as an optical disc. Light reflected from the optical disc is passed through a beam splitter 21 and then injected into the VCSEL 10. For practical reasons, the emission wavelength for the VCSEL is typically selected to be substantially longer than the wavelength of the injected light. Light of a shorter wavelength than the emission wavelength for the VCSEL can easily be coupled into the cavity, such that this injection creates electron-hole pairs in the active region of the VCSEL and thereby increases the gain of the laser. If a sufficient amount of light is injected into the active region of the VCSEL, the gain of the VCSEL will become higher than the lasing threshold and emission will start. Preferably, the injected light has a polarization that is different from the free-running (i.e. without injection) polarization of the VCSEL, such that sufficient injection leads to a polarization switch for the light emitted from the VCSEL. This emission, occurring in a direction that is counter-propagating to the incident light, will impinge upon the beam splitter 21 and, due to its wavelength being longer than that of the injected light or its polarization orthogonal, reflect towards a polarizer 22 and a detector 23. Depending on the circumstances, the beam splitter could be a dichroic mirror or a polarizing beam splitter.

A first way of employing the VCSEL 10 is what we here call polarization-switching. This is based on using the injected light to increase the gain for a polarization mode that is orthogonal to the free-running (i.e. without injection) mode of the VCSEL, such that a switch in polarization mode is obtained for the VCSEL when the injected light is sufficiently high in power. By passing the emission from the VCSEL through a polarizer (such as polarizer 22), it is straightforward to detect whether such polarization-switching has occurred or not.

A second way of employing the VCSEL 10 is what we call threshold-switching. In this case, the VCSEL is driven just below its lasing threshold. When a sufficient amount of light is injected into the VCSEL, the gain increases to above the lasing threshold, and the VCSEL starts to emit light.

Common to both above ways of using the VCSEL for improving the optical read-out, is that a certain level of injected light is required in order to achieve a switching of the VCSEL.

If the amount of injected light is low, the VCSEL 10 will not be affected. If polarization-switching is employed, the VCSEL will still emit in its free-running polarization mode. If threshold-switching is employed, the gain of the VCSEL will still be below the lasing threshold. Hence, substantially no light from the VCSEL 10 reaches the detector 23.

As soon as the amount of injected light is sufficiently high, the VCSEL 10 will switch as described above. This switch is detected, and the information contained in the injected light can be extracted. One very beneficial characteristic of this scheme is that the power emitted by the VCSEL is typically much higher than the power of the injected light. Hence, the read-out is improved and the signal-to-noise ratio for the read-out is increased.

As shown in Fig.2, however, a set-up comprising a beam splitter 21 and dual beam-paths must be implemented in order to use this scheme.

According to the embodiments of the present invention, use is made of a VCSEL emitting in two directions. The requirement of using a beam splitter is thus completely eliminated, and the design of the device can be made more compact.

Fig.3 of the drawings schematically shows this simplified set-up according to the present invention. The two-way emitting VCSEL 30 is positioned in front of a polarizer 31 and a photodetector 32. In its tree-running state, light from the VCSEL 30 has a polarization that is blocked by the polarizer 31. Therefore, without sufficient injection of light into the VCSEL, no light reaches the detector 32. When a sufficient amount of light is injected into the VCSEL, the emission will switch to another polarization state, so that the emitted light passes through the polarizer 31. Such light will then immediately be detected by the photodetector 32.

In an alternative embodiment, threshold-switching is employed. In this case, the polarizer 31 is optional, since the VCSEL does not emit any light unless sufficient injected power is present. Any lasing emission from the VCSEL then emanates from injection, and the emitted light can be detected by means of the detector 32.

It should be noted that the light injected into the VCSEL is generally of a wavelength different from that emitted by the VCSEL. Therefore, the emission from the VCSEL will not interfere with the information read-out. As stated above, the injected light typically has a shorter wavelength than the emission wavelength of the VCSEL.

Although, according to the present invention, the VCSEL is capable of emitting light in two directions, only light emitted through its rear is used for read-out of information. Light emitted through its front side is not used for this purpose. So, the VCSEL should be capable of receiving injection light from one side, and emitting secondary light from another side, such that the emitted secondary light propagates in the same direction as the injected light. Since injection of light should be possible through the first side of the VCSEL, there will typically also be some emission of secondary light from this side.

In the following, a number of different ways of providing transmission through the substrate of the VCSEL will be described.

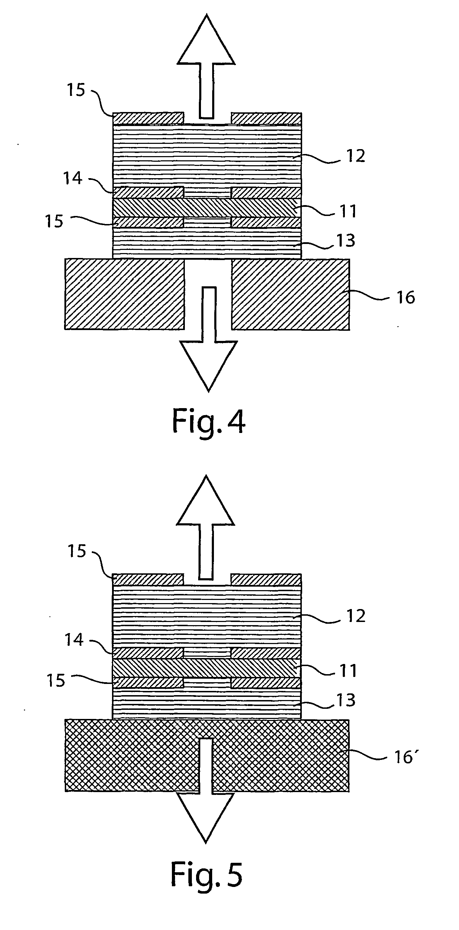

A first and very direct way of transmitting light through the substrate of the VCSEL is schematically shown in Fig.4. In the case shown, a hole has been provided in the substrate 16, such that light generated in the VCSEL can be emitted through the rear of said VCSBL. It should be pointed out that methods for providing a hole through the substrate of a VCSEL, by etching or drilling, are known by those skilled in the art-and will not be explained in further detail here.

Another way of providing a bottom emitting VCSEL is schematically shown in Fig.5. In this case, the semiconductor substrate originally used for the manufacture of the VCSEL has been removed and replaced by a substrate 16' that is transparent to the emission wavelength of the laser. For example, when the emission wavelength of the VCSEL is about 850 nm, the transparent substrate could comprise gallium-phosphide (GaP) or sapphire (Al₂O₃). Techniques for removing and replacing the substrate are known in the art of semiconductor manufacturing, one example being wafer-bonding techniques.

Moreover, it is possible to originally grow the VCSEL on the transparent substrate 16'. In this case, the need for replacement of the substrate subsequent to growing the VCSEL is eliminated.

Regardless of the way in which the substrate of the VCSEL 30 has been made transmitting, be it by providing a hole in the substrate or by having the substrate transparent, a detector 32 can conveniently be arranged adjacent to the substrate in order to monitor the output from the VCSEL. Advantageously, the VCSEL and the detector can be assembled into a single package, where the VCSEL is integrated with the detector.

Hence, the present invention provides a very compact read-out arrangement, which incorporates a vertical-cavity surface-emitting laser (VCSEL) for improving the quality of the read-out signal reflected from the information carrier. The VCSEL has a substrate that transmits the emission from the active regions of the VCSEL. Thereby, the need for beam-splitters in the detection branch of the device is completely eliminated, and the complexity of the device is reduced. It is envisaged that the present invention will have valuable applicability in future high-density optical disc-drives, and in particular in SFFO-disc drives.

## Claims

1. An arrangement for read-out of information from an optical information carrier, comprising
a light source for illuminating said information carrier, and
an optical system for receiving light reflected from the information carrier and for injecting this reflected light into a vertical-cavity surface-emitting laser (VCSEL) (30), said VCSEL having a front side for receiving said reflected light and a rear opposite said front side,
**characterized in that** the VCSEL is configured to emit secondary light, responsive to the injected light, through its rear at a wavelength which is longer than the wavelength of said injected light, and
**in that** a photodetector (32) is provided adjacent said rear to detect secondary light emitted through the rear of the VCSEL.

2. An arrangement as claimed in claim 1, further comprising a polarizer (31) arranged between said rear of the VCSEL (30) and said photodetector (32) for allowing only light of a predetermined polarization to reach the photodetector.

3. An arrangement as claimed in claim 1 or 2, wherein the VCSEL is configured to emit light through its rear by way of a hole provided in a substrate of the VCSEL.

4. An arrangement as claimed in claim 1 or 2, wherein the VCSEL is configured to emit light through its rear by way of a substrate of the VCSEL being transparent to the emitted wavelength.

5. An optical drive, comprising an arrangement for read-out according to any one of the preceding claims.

6. Use of a vertical-cavity surface-emitting laser (VCSEL) capable of receiving injection of light from a first side and capable of emitting light from a second side for enhancing read-out of information from an optical information carrier, wherein said information carrier is illuminated by light from a light source, **characterized in that** light thus reflected from the information carrier is injected into the VCSEL from the first side and read-out is performed by monitoring secondary light emitted by said VCSEL, responsive to the injected light, from the second side opposite said first side, wherein said secondary light has a wavelength that is longer than the wavelength of said injected light.

## Patentansprüche

1. Anordnung zum Auslesen von Informationen aus einem optischen Informationsträger mit
einer Lichtquelle zur Beleuchtung des Informationsträgers und
einem optischen System, um von dem Informationsträger reflektiertes Licht zu empfangen und dieses reflektierte Licht in einen Vertical-Cavity Surface-Emitting Laser (VCSEL) (30) zu injizieren, wobei der VCSEL eine Vorderseite zum Empfang des reflektierten Lichts und eine der Vorderseite gegenüberliegende Rückseite aufweist,
**dadurch gekennzeichnet, dass** der VCSEL so ausgeführt ist, dass er in Reaktion auf das injizierte Licht durch seine Rückseite Sekundärlicht mit einer Wellenlänge, die länger als die Wellenlänge des injizierten Lichts ist, emittiert, und
dass ein Photodetektor (32) in Angrenzung an die Rückseite vorgesehen ist, um durch die Rückseite des VCSELs emittiertes Sekundärlicht zu detektieren.

2. Anordnung nach Anspruch 1, welche weiterhin einen Polarisator (31) aufweist, der zwischen der Rückseite des VCSELs (30) und dem Photodetektor (32) angeordnet ist, damit nur Licht einer vorgegebenen Polarisation den Photodetektor erreichen kann.

3. Anordnung nach Anspruch 1 oder 2, wobei der VCSEL so ausgeführt ist, dass er Licht durch seine Rückseite über ein in einem Substrat des VCSELs vorgesehenes Loch emittiert.

4. Anordnung nach Anspruch 1 oder 2, wobei der VCSEL so ausgeführt ist, dass er Licht durch seine Rückseite über ein für die emittierte Wellenlänge durchlässiges Substrat des VCSELs emittiert.

5. Optisches Laufwerk mit einer Anordnung zum Auslesen nach einem der vorangegangenen Ansprüche.

6. Einsatz eines Vertical-Cavity Surface-Emitting Lasers (VCSEL), der imstande ist, eine Lichtinjektion von einer ersten Seite zu empfangen und Licht von einer zweiten Seite zu emittieren, um das Auslesen von Informationen aus einem optischen Datenträger zu verbessern, wobei der Informationsträger durch Licht von einer Lichtquelle beleuchtet wird, **dadurch gekennzeichnet, dass** von dem Informationsträger auf diese Weise reflektiertes Licht in den VCSEL von der ersten Seite injiziert und das Auslesen durch Überwachen des Sekundärlichts, welches von dem VCSEL in Reaktion auf das injizierte Licht von der, der ersten Seite gegenüberliegenden, zweiten Seite emittiert wird, durchgefiihrt wird, wobei das Sekundärlicht eine Wellenlänge hat, die länger als die Wellenlänge des injizierten Lichts ist.

## Revendications

1. Montage pour la lecture de l'information à partir d'un support optique d'information, comprenant
une source lumineuse pour illuminer ledit support d'information, et
un système optique pour recevoir la lumière qui est réfléchie à partir du support d'information et pour injecter cette lumière réfléchie dans un laser à cavité verticale et à émission par la surface (VCSEL) 30, ledit VCSEL ayant un côté avant pour recevoir ladite lumière réfléchie et un côté arrière à l'opposite dudit côté avant,
**caractérisé en ce que** le VCSEL est configuré de manière à émettre la lumière secondaire qui est sensible à la lumière injectée par le biais de son côté arrière à une longueur d'onde qui est supérieure à la longueur d'onde de ladite lumière injectée, et
**en ce que** le détecteur photoélectrique (32) est disposé d'une manière adjacente au côté arrière pour détecter la lumière secondaire qui est émise par le biais du côté arrière du VCSEL.

2. Montage selon la revendication 1, comprenant encore un polariseur (31) qui est disposé entre ledit côté arrière du VCSEL (30) et ledit détecteur photoélectrique (32) afin de permettre que seule la lumière ayant une polarisation déterminée atteigne le détecteur photoélectrique.

3. Montage selon la revendication 1 ou 2, dans lequel le VCSEL est configuré de manière à émettre la lumière par le biais de son côté arrière à travers un trou qui est pratiqué dans un substrat du VCSEL.

4. Montage selon la revendication 1 ou 2, dans lequel le VCSEL est configuré de manière à émettre la lumière par le biais de son côté arrière au moyen d'un substrat du VCSEL qui est transparent à la longueur d'onde émise.

5. Unité optique d'entraînement comprenant un montage pour la lecture selon l'une quelconque des revendications précédentes 1 à 4.

6. Utilisation d'un laser à cavité verticale et à émission par la surface (VCSEL) qui est capable de recevoir une injection de lumière à partir d'un premier côté et qui est capable d'émettre la lumière à partir d'un deuxième côté pour améliorer la lecture à partir d'un support optique d'information où ledit support d'information est illuminé par la lumière en provenance d'une source lumineuse, **caractérisée en ce que** la lumière qui est ainsi réfléchie à partir du support d'information est injectée dans le VCSEL à partir du premier côté et **en ce que** la lecture est exécutée par le contrôle de la lumière secondaire qui est émise par ledit VCSEL, en réaction à la lumière injectée, à partir du deuxième côté à l'opposite dudit premier côté où ladite lumière secondaire présente une longueur d'onde qui est supérieure à la longueur d'onde de ladite lumière injectée.
